# EUROPÄISCHE PATENTSCHRIFT

(11) **EP 0 762 667 B1**
(45) Veröffentlichungstag und Bekanntmachung des Hinweises auf die Patenterteilung: **02.01.2003**
(21) Anmeldenummer: 96114087.8
(22) Anmeldetag: 03.09.1996
(51) Int. Cl.: H04B 3/46, G01R 29/027, G01R 31/02

(54) **Vorrichtung zum Messen der Signallaufzeit einer digitalen Übertragungseinrichtung**
Measuring device of the propagation time in a digital transmission system
Dispositif de mesure du temps de parcours d'un signal dans un système de transmission numérique

(30) Priorität: 07.09.1995 DE 19533113
(43) Veröffentlichungstag der Anmeldung: 12.03.1997
(73) Patentinhaber: Infineon Technologies AG, 81669 München (DE)
(72) Erfinder: Alger-Meunier, Michael, Dr.-Ing., 85540 Haar (DE); Ammar, Yousif, Dr.rer.nat., 81675 München (DE); Kramer, Ronalf, Dipl.-Ing., 81247 München (DE)
(74) Vertreter: Barth, Stephan Manuel, Dr.

(56) Entgegenhaltungen:
- EP-A- 0 592 209
- US-A- 5 381 444

## Beschreibung

Die Erfindung betrifft eine Vorrichtung zum Messen der Signallaufzeit einer zwischen eine übergeordnete Stelle und eine untergeordnete Stelle geschalteten digitalen Übertragungseinrichtung.

Die Signallaufzeit einer Übertragungseinrichtung kann je nach Ausführung stark schwanken. Bei Verwendung einer Drahtverbindung als Übertragungsmedium ist die Signallaufzeit im wesentlichen von der Leitungslänge abhängig. Zur Instandhaltung der Übertragungseinrichtung, bei Anwendungen mit Radio-In-The-Loop (RITL) und beim Einsatz in Systemen mit schnurlosen Telefonendgeräten nach DECT-Standard ist es notwendig, die Leitungslaufzeit jeder Strecke und ggf. die sich hieraus ergebende proportionale Leitungslänge individuell bestimmen zu können. Derartige Messungen werden bisweilen manuell unter Zuhilfenahme externer Meßgeräte je nach Bedarf vorgenommen.

Der Erfindung liegt die Aufgabe zugrunde, eine Vorrichtung anzugeben, bei der die Messung der Signallaufzeit jederzeit und automatisch vorgenommen werden kann.

Die Aufgabe wird durch eine Vorrichtung gemäß Patentanspruch 1 gelöst.

Ausgestaltungen und Weiterbildungen des Erfindungsgedankens sind Gegenstand von Unteransprüchen.

Die Messung einer digitalen Übertragungseinrichtung erfolgt durch eine übergeordnete Stelle in Wechselwirkung mit einer über die digitale Übertragungseinrichtung verbundenen untergeordneten Stelle, wobei die bei der Nutzsignalübertragung überlagerten Takte sowie die Abhängigkeit des einen Takts vom anderen zur Messung herangezogen wird. Der zusätzliche Aufwand für die Meßeinrichtung ist relativ gering, da Mittel zum Takten und zum Rückgewinnen des Taktes in der Regel sowohl bei übergeordneter als auch bei untergeordneter Stelle bereits vorhanden sind. Zusätzlich ist demnach nur eine Phasenvergleichseinrichtung vorzusehen, die die Taktsignale von zu sendendem Nutzsignal und empfangenen Nutzsignal in der übergeordneten Stelle auswertet. Daraus wird in der nachfolgenden Recheneinrichtung der dementsprechende Wert der Signallaufzeit ermittelt.

Für den Fall, daß die Signallaufzeiten in der übergeordneten und untergeordneten Stelle nicht vernachlässigbar sind, wird nach Umrechnung der Phasendifferenz in eine Signallaufzeit davon die Signallaufzeiten in der übergeordneten und/oder untergeordneten Stelle substrahiert. Das Subtraktionsergebnis wird aufgrund der Verdopplung der Signallaufzeit in Folge von Hin- und Rücklauf des Signals durch zwei geteilt.

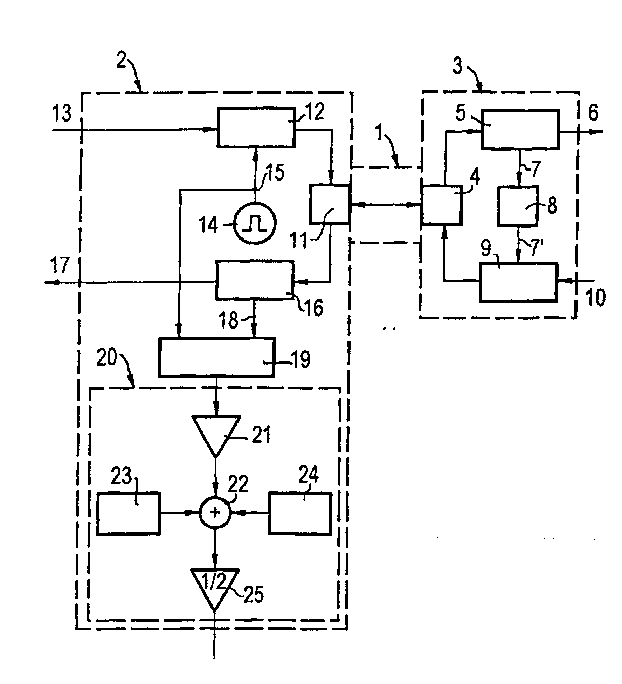

Die Erfindung wird nachfolgend anhand des in der einzigen Figur der Zeichnung dargestellten Ausführungsbeispiels näher erläutert.

Bei der als Ausführungsbeispiel gezeigten erfindungsgemäßen Vorrichtung ist eine Übertragungseinrichtung 1, beispielsweise eine Telefonleitung, zwischen eine übergeordnete Stelle 2, beispielsweise eine Vermittlungsstelle, und eine untergeordnete Stelle 3, beispielsweise eine Teilnehmerendstelle, geschaltet. Die untergeordnete Stelle 3 enthält eine Leitungsanpaß- und Gabelschaltung 4, die mit der Übertragungseinrichtung 1 bidirektional gekoppelt ist. Über die Übertragungseinrichtung 1 empfangene Signale werden von der Leitungsanpaßund Gabelschaltung 4 einer Empfangseinrichtung 5 zugeführt, die daraus ein Nutzsignal 6 sowie ein Taktsignal 7 gewinnt. Das Taktsignal 7 wird direkt oder unter Zwischenschaltung einer Synchronisiereinrichtung 8 als Taktsignal 7' einer Sendeeinrichtung 9 zugeführt, die das Taktsignal 7' einem Nutzsignal 10 überlagert und das daraus resultierende Signal über die Leitungsanpaß- und Gabelschaltung 4 sowie die Übertragungseinrichtung 1 an die übergeordnete Stelle 2 sendet.

Die übergeordnete Stelle 2 enthält ebenfalls eine mit der Übertragungseinrichtung 1 bidirektional gekoppelte Leitungsanpaß- und Gabelschaltung, nämlich die Leitungsanpaß- und Gabelschaltung 11, die ein Signal von einer Sendeeinrichtung 12 erhält. In der Sendeeinrichtung 12 wird einem Nutzsignal 13 ein durch einen Taktgenerator 14 erzeugtes Taktsignal 15 überlagert. Die Leitungsanpaß- und Gabelschaltung 11 ist zudem mit einer Empfangseinrichtung 16 verbunden, die von der untergeordneten Stelle 3 gesendete Signale empfängt und daraus ein Nutzsignal 17 sowie ein Taktsignal 18 gewinnt.

Zur Ermittlung der Signallaufzeit in der Übertragungseinrichtung 1 werden die Taktsignale 15 und 18 einer Phasenvergleichseinrichtung 19, beipsielsweise einem Phasendetektor, zugeführt, der die Phasenverschiebung zwischen beiden Taktsignalen 15 und 18 ermittelt. Das Vergleichsergebnis wird nachfolgend einer Recheneinrichtung 20 zugeführt. Diese bewertet das Vergleichsergebnis mittels eines Koeffizientenmultiplizierers 21 mit einem Umrechnungsfaktor, der das Vergleichsergebnis in die entsprechende zeitliche Dimension überführt. Bei entsprechender Auslegung der Phasenvergleichseinrichtung 19 kann der Umrechnungsfaktor jedoch gleich 1 sein und somit kann der Koeffizientenmultiplizierer entfallen. Dem Koeffizientenmultiplizierer 21 folgt ein Subtrahierer 22, der die Inhalte zweier Register 23 und 24 von dem bewerteten Phasenvergleichsergebnis subtrahiert. In den Registern 23 und 24 sind die Signallaufzeiten bei der übergeordneten Stelle 2 bzw. der untergeordneten Stelle 3 abgelegt. Im Falle, daß die Signallaufzeiten in der übergeordneten Stelle 2 und/oder untergeordneten Stelle 3 gegenüber der Signallaufzeit in der Übertragungseinrichtung 1 vernachlässigbar sind, können das Register 23, das Register 24 und/oder der Subtrahierer 22 entfallen. Das Subtraktionsergebnis wird anschließend durch einen weiteren Koeffizientenmultiplizierer 25 ein die Signallaufzeit auf der Übertragungseinrichtung 1 wiedergebendes Signal 26 bildend halbiert.

Zur Laufzeitmessung wird also die in der übergeordneten Stelle vorhandene Information über die Phasenlage des Sendetaktes im Vergleich zum Empfangstakt ausgewertet. Der Sendetakt ist ein Signal, welches synchron zu den von der übergeordneten Stelle gesendeten Impulsen ist. Der Empfangstakt ist synchron zu dem in der übergeordneten Stelle empfangenen Impulsen der untergeordneten Stelle. Sende- und Empfangstakt werden dabei in bekannter Weise in der untergeordneten Stelle miteinander verknüpft. Demnach setzt sich die Phasenlage von Sende- und Empfangstakt in der übergeordneten Stelle aus jeweils einer konstanten, bekannten Verzögerungszeit in der übergeordneten und der untergeordneten Stelle sowie aus einem durch die doppelte Leitungslaufzeit gegebenen Anteil zusammen. Die doppelte Leitungslaufzeit ergibt sich dadurch, daß die Übertragungseinrichtung sowohl vom Sende- als auch vom Empfangssignal je einmal durchlaufen werden muß. Die Sende- und Empfangstakt zugrundeliegende Taktperiode kann verhältnismäßig lang sein, wenn nur jeder n-te Sende- bzw. Empfangsimpuls ausgewertet wird. Ein Zähler startet dabei mit dem Sendeimpuls und zählt bis zum Eintreffen des Empfangsimpulses. Das Ergebnis wird als Binärzahl mit der Auflösung der Zählgeschwindigkeit beispielsweise als Anzeige oder zur weiteren Verarbeitung in einer Datenverarbeitungseinrichtung ausgegeben. Durch entsprechende Wahl der Zählgeschwindigkeit ist es möglich, die Binärzahl in einer festen zeitlichen Einheit oder etwa als Leitungslänge auszugeben.

Mit der vorliegenden Erfindung kann die Messung in kurzen Abständen (z. B. 50 ms) fortlaufend wiederholt werden. Somit können neben langsamen Laufzeitänderungen, wie sie beispielsweise durch Temperaturschwankungen verursacht werden, auch schnelle Änderungen festgestellt werden, deren Erkennung insbesondere bei drahtlosen, mobilen Anwendungen von Bedeutung ist.

Darüberhinaus kann die Initiierung einer Laufzeitmessung nicht nur von der übergeordneten Stelle aus erfolgen, sondern auch von der untergeordneten Stelle aus, indem diese durch eine spezielle Nachricht beispielsweise über einen Signalisierungskanal eine Messung anfordert. Im Gegenzug kann die übergeordnete Stelle das Ergebnis der Laufzeitmessung beispielsweise mittels eines Kontroll-, Daten- oder Signalisierungskanal der untergeordneten Stelle mitteilen.

Schließlich kann die Synchronisiereinrichtung 8 derart ausgeführt werden, daß eine vorgegebene Verzögerungszeit der untergeordneten Stelle einstellbar ist, wodurch eine konstante, beispielsweise einem Normwert entsprechende Laufzeit in der untergeordneten Stelle erzielt wird.

## Patentansprüche

1. Vorrichtung zum Messen der Signallaufzeit einer zwischen eine übergeordnete Stelle (2) und eine untergeordnete Stelle (3) geschalteten digitalen Übertragungseinrichtung (1), bei der die übergeordnete und untergeordnete Stelle (2, 3) jeweils eine Sendeeinrichtung (12, 9) zum Senden durch jeweils ein Taktsignal getakteter Nutzsignale über die Übertragungseinrichtung (1) an die jeweilige Gegenstelle (3, 2) und eine Empfangseinrichtung (16, 5) zum Empfang der von der jeweiligen Gegenstelle (3, 2) getakteten Nutzsignale aufweisen, wobei die Empfangseinrichtungen (16, 5) Mittel aufweisen, die das dem jeweiligen Nutzsignal überlagerte Taktsignal abtrennen,
die übergeordnete Stelle (2) Mittel aufweist, die das zu sendende Nutzsignal durch ein vorgegebenes Taktsignal (15) takten und die untergeordnete Stelle (3) Mittel aufweist, die das zu sendende Nutzsignal durch ein aus dem von seiner Empfangseinrichtung (5) abgetrennten Taktsignal (7) hergeleitetes Taktsignal (7') takten,
und die Übergeordnete Stelle (2) eine Phasenvergleichseinrichtung (19), die das gegebene Taktsignal (15) mit dem von seiner Empfangseinrichtung (16) abgetrennten Taktsignal (18) vergleicht, und eine Recheneinrichtung (20) aufweist, die aus dem Vergleichsergebnis der Phasenvergleichseinrichtung (19) die Signallaufzeit (26) berechnet.

2. Vorrichtung nach Anspruch 1,
**dadurch gekennzeichnet,**
**daß** die Recheneinrichtung (20) das Vergleichsergebnis mit einem Umrechnungsfaktor bewertet, davon in Registern (23, 24) abgelegte Signallaufzeiten der übergeordneten und untergeordneten Stellen (2, 3) subtrahiert und die sich daraus ergebende Differenz durch zwei teilt, um die Signallaufzeit der Übertragungseinrichtung (1) zu erhalten.

3. Vorrichtung nach Anspruch 1 oder 2,
**dadurch gekennzeichnet,**
**daß** die Recheneinrichtung (20) durch Multiplikation der signallaufzeit mit einem weiteren Umrechnungsfaktor eine entsprechende Leitungslänge ermittelt.

## Claims

1. Device for measuring the signal transit time of a digital transmission device (1) which is connected between a superordinate point (2) and a subordinate point (3), in which the superordinate and subordinate points (2, 3) each have a transmission device (12, 9) for transmitting useful signals which are each clocked by means of a clock signal to the respective opposite point (3, 2) via the transmission device (1), and a receiver device (16, 5) for receiving the useful signals which are clocked by the respective opposite point (3, 2), the receiver devices (16, 5) having means which separate off the clock signal which is superimposed on the respective useful signal,
the superordinate point (2) having means which clock the useful signal to be transmitted by means of a predefined clock signal (15), and the subordinate point (3) having means which clock a clock signal (7') derived from the clock signal (7) which is separated off by its receiver device (5),
and the superordinate point (2) having a phase comparator device (19) which compares the given clock signal (15) with the clock signal (18) which is separated off from its receiver device (16), and the superordinate point (2) has a computing device (20) which calculates the signal transit time (26) from the comparison result of the phase comparator device (19).

2. Device according to Claim 1, **characterized in that** the computing device (20) evaluates the comparison result with a conversion factor, subtracts therefrom signal transit times of the superordinate and subordinate points (2,3) which are stored in registers (23, 24), and divides the resulting difference by two in order to obtain the signal transit time of the transmission device (1).

3. Device according to Claim 1 or 2, **characterized in that** the computing device (20) determines a corresponding line length by multiplying the signal transit time by a further conversion factor.

## Revendications

1. Dispositif pour mesurer le temps de propagation d'un signal d'un dispositif de transmission numérique (1), qui est branché entre un poste de rang supérieur (2) et un poste de rang inférieur (3), et
dans lequel le poste de rang supérieur et le poste de rang inférieur (2, 3) possèdent respectivement un dispositif d'émission (12, 9) pour émettre, à l'aide respectivement d'un signal de cadence, des signaux utiles commandés de façon cadencée par l'intermédiaire respectivement d'un signal de cadence, au poste antagoniste respectif (3, 2) par l'intermédiaire du dispositif de transmission (1), et
un dispositif de réception (16, 5) pour la réception des signaux utiles commandés de façon cadencée par le poste antagoniste respectif (3, 2), les dispositifs de réception (16, 5) comportant des moyens qui séparent le signal de cadence superposé au signal utile respectif,
le poste de rang supérieur (2) comporte des moyens qui commandent de façon cadencée le signal utile à émettre, au moyen d'un signal de cadence prédéterminé (15), et le poste de rang inférieur (3) comporte des moyens qui commandent de façon cadencée le signal utile à émettre, au moyen d'un signal de cadence (7') tiré du signal de cadence (7) séparé par son dispositif de réception (5),
et le poste de rang supérieur (2) possède un dispositif de comparaison de phase (19), qui compare le signal de cadence donné (15) au signal de cadence (18) séparé par son dispositif de réception (16), et comporte un dispositif de calcul (20), qui calcule le temps (26) de propagation du signal à partir du résultat de la comparaison du dispositif de comparaison de phase (19).

2. Dispositif selon la revendication 1, **caractérisé en ce que** le dispositif de calcul (20) pondère le résultat de la comparaison avec un facteur de conversion, soustrait de ce résultat l'un des signaux de temps de propagation, mémorisés dans des registres (23, 24), du poste de rang supérieur et du poste de rang inférieur (2, 3) et divise par deux la différence ainsi obtenue, pour obtenir le temps de propagation du signal dans le dispositif de transmission (1).

3. Dispositif selon la revendication 1 ou 2, **caractérisé en ce que** le dispositif de calcul (20) détermine une longueur de ligne correspondante, par multiplication du temps de propagation du signal par un autre facteur de conversion.
